(19) Europäisches Patentamt
European Patent Office
Office européen des brevets

(11) EP 1 260 867 A1

(12) EUROPEAN PATENT APPLICATION

(43) Date of publication:
27.11.2002 Bulletin 2002/48

(51) Int Cl.[7]: G03F 7/32, B41C 1/10

(21) Application number: 02011306.4

(22) Date of filing: 22.05.2002

(84) Designated Contracting States:
AT BE CH CY DE DK ES FI FR GB GR IE IT LI LU MC NL PT SE TR
Designated Extension States:
AL LT LV MK RO SI

(30) Priority: 22.05.2001 JP 2001152082

(71) Applicant: Fuji Photo Film Co., Ltd.
Minami-Ashigara-shi, Kanagawa (JP)

(72) Inventors:
- Itakura, Ryosuke
  Yoshida-cho, Haibara-gun, Shizuoka-ken (JP)
- Aoshima, Keitaro
  Yoshida-cho, Haibara-gun, Shizuoka-ken (JP)

(74) Representative: Grünecker, Kinkeldey,
Stockmair & Schwanhäusser Anwaltssozietät
Maximilianstrasse 58
80538 München (DE)

(54) **Developing solution composition and process for forming image using the composition**

(57) A developer composition for developing a lithographic printing plate having a negative recording layer on which an image is recorded via an infrared laser, the composition containing a nonionic surfactant, and a process for forming an image on a lithographic printing plate. The process comprises the steps of imagewise exposing a lithographic printing plate having a negative recording layer on which an image is recorded via an infrared ray and which contains an infrared ray absorbent, a radical generator and a radically polymerizable compound, and then developing the lithographic printing plate with the developer composition containing a nonionic surfactant.

EP 1 260 867 A1

## Description

### BACKGROUND OF THE INVENTION

### Field of the Invention

The present invention relates to a developing solution composition suitable for use with a lithographic printing plate having a negative recording layer on which image formation is carried out, wherein an image portion is cured by a polymerization or crosslinking reaction via exposure to an infrared laser, and to a process for forming an image on a lithographic printing plate having a negative recording layer, using the composition.

### Description of the Related Art

As systems for direct plate making from digital computer data, for example, (i) a system utilizing an electrophotographic process, (ii) a system using photopolymerization by exposure via a laser emitting blue or green light, (iii) a system in which a silver salt is accumulated on a photosensitive resin, and (iv) a system utilizing a silver salt diffusion transfer process have been proposed.

However, the system (i) utilizing an electrophotographic process includes complicated steps for image formation, such as charging, exposing and developing, which require complicated and large-scale equipment. In the system (ii) using photopolymerization, a plate material having high sensitivity to blue or green light is used, and thus handling the material in roomlight must be avoided. The systems (iii) and (iv) have disadvantages in that processing steps, such as developing, are complicated owing to the use of a silver salt and generation of waste water containing silver.

The development of lasers has been remarkable in recent years, and in particular, solid lasers and semiconductor lasers emitting an infrared rays with wavelengths of from 760 to 1,200 nm and having high output power and small sizes are becoming easily available. These lasers are considerably useful as recording light sources for direct plate making from digital computer data. However, most photosensitive recording materials that are practically useful have a sensitive wavelength in the visible light range at a wavelength of 760 nm or lower, and therefore, image recording with infrared ray lasers has not been possible. Accordingly, a material on which image recording can be carried out with an infrared laser is demanded.

A negative image recording material that can be recorded with an infrared laser, comprising an infrared ray absorbent, an acid generator, a resol resin and a novolak resin has been disclosed in United States Patent (USP) No. 5,340,699. The negative image recording material is imagewise exposed to laser light and then is generally, developed with an alkaline aqueous solution to form an image. For development, an automatic developing machine is generally used.

For example, Japanese Patent Application Publication (JP-B) No. 7-103171 discloses a recording material formed with a cyanine dye having a particular structure, an iodonium salt and an addition-polymerizable compound having an ethylenic unsaturated double bond, which recording material does not require a heat treatment after imagewise exposure. In the development of the material, an aqueous solution of sodium carbonate is used. This developing solution is preferable since it causes less damage to an exposed portion of the material, but it is poor in solubility with respect to the image recording material. Therefore, the developing solution cannot completely remove a non-exposed portion of a photosensitive layer, causing problems such as contamination in the non-image portion upon printing.

JP-A No. 8-108621 discloses a negative image forming material containing a photothermal conversion substance, a thermally polymerizable resin and a thermal polymerization initiator. Development thereof is carried out by using an aqueous solution containing a strong alkali, such as potassium silicate, and addition of an anionic surfactant and amphoteric surfactant is suggested. The developing solution has a high capacity for removal of non-exposed portion of the photosensitive layer, preventing contamination in the non-image portion. However, because it is also high in permeability to the photosensitive layer in the exposed portion, undesirable dissolution of the image portion after development is caused, and problems arrises such as a tendency for causing dropouts of images, and insufficient printing durability to carry out continuous printing.

### SUMMARY OF THE INVENTION

An object of the invention is to provide a developer composition that is preferably applied to a lithographic printing plate having a negative recording layer capable of undergoing directly recording from digital computer data using a solid laser or a semiconductor laser emitting an infrared ray, and that has excellent image formation properties but causes no time-lapse reduction in developing capacity or printing durability due to characteristics of the developer. Another object of the invention is to provide a process for forming an image on a negative lithographic printing plate

using the developer composition.

The inventors have focused their attention on physical properties of a negative image forming material and a developer, and as a result of earnest investigations, have found that the above-mentioned problems can be solved by increasing permeability of a developer containing a carbonate, with respect to a non-image portion of a recording layer, while maintaining the characteristics of the developer which led to completion of the present invention.

A first aspect of the present invention relates to a composition for developing a lithographic printing plate including a negative recording layer on which an image is recorded by exposure to an infrared laser, the composition comprising a nonionic surfactant.

The nonionic surfactant is preferably a compound having an inorganicity/organicity value in a range of from 1.0 to 3.0, and the developer composition preferably has a pH level in a range of from 9 to 14.

A second aspect of the invention relates to a process for forming an image on a lithographic printing plate, the process comprising the steps of : imagewise exposing an original lithographic printing plate including a negative recording layer on which an image is recorded by exposure to an infrared ray, the negative recording layer containing an infrared ray absorbent, a radical generator and a radically polymerizable compound; and then developing the lithographic printing plate via a developer composition containing a nonionic surfactant.

Although the mechanism resulting in the effects of the present invention are not completely clear, it is believed that combinated use of the nonionic surfactant, having a structural property value in a particular range, in an alkaline developing solution decreases the permeability of the developing solution with respect to an image portion of the recording layer in order to prevent damage to the image portion, and thus adverse affects to image forming capacities and printing durability are suppressed. It is also believed that by adjusting the pH level of the developer composition to an alkaline range of from 9 to 14, the developing solution can selectively and sufficiently permeate a non-exposed portion, i.e., the non-image portion, which undergoes no curing reaction, so as to assure more preferable development.

The present invention is particularly effective in the case where an amount of exposure to infrared irradiation on an image recording material is small, i.e., when developing a photosensitive material in which an exposed portion has not yet sufficiently underdone a curing reaction, and thus image formation can be carried out with a smaller amount of exposure. Therefore, high-sensitivity image formation can be attained by the developer composition of the present invention.

## DETAILED DESCRIPTION OF THE INVENTION

A characteristic feature of a developer composition of the present invention is that a nonionic surfactant is contained in an alkaline aqueous solution.

It is preferable that a base of the developer composition of the present invention and a replenisher thereof are a weak alkaline aqueous solution having a pH level in a range of from 9 to 14 and containing a nonionic surfactant as an additive.

The weak alkaline aqueous solution preferably has a pH level in a range of from 9 to 14, more preferably from about 10 to 13.5, and particularly preferably about from 11 to 13. The pH values referred to herein with regards to the invention are values measured at 25°C.

Examples of an alkaline agent for an alkaline aqueous solution preferably used in the invention include inorganic alkaline agents, such as sodium carbonate, sodium hydrogencarbonate, potassium carbonate, potassium hydrogencarbonate, lithium carbonate, lithium hydrogencarbonate, ammonium carbonate, ammonium hydrogencarbonate, sodium hydroxide, potassium hydroxide, lithium hydroxide, trisodium phosphate, tripotassium phosphate, triammonium phosphate, disodium phosphate, dipotassium phosphate, diammonium phosphate, sodium borate, potassium borate and ammonium borate, potassium citrate, tripotassium citrate, sodium citrate, sodium silicate and potassium silicate.

Anhydrides and hydrates of these alkalis and alkaline salts may be used. Two or more kinds of the alkalis and alkaline salts may be used in combination.

Preferred examples thereof also include organic alkaline agents, such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

An added amount of the alkaline agent is preferably in a range of from 0.1 to 10% by weight, and more preferably in a range of from 0.3 to 7% by weight, based on an amount of the developer composition or the replenisher composition. In a case where the added amount is less than 0.1% by weight, solubility of a non-exposed portion of a photosensitive layer is decreased, and the non-image portion may be contaminated, whereas when the alkaline agent is added in an amount exceeding 10% by weight, there is a tendency for printing durability to become poor upon printing, and therefore, neither case is preferred.

The developing solution used in a process of the invention necessarily includes a nonionic surfactant. The

surfactant is useful for accelerating development and for dispersing dusts. The surfactant that can be used in the present invention necessarily contains a nonionic surfactant, and the addition of the particular surfactant accelerates dissolution of the non-exposed portion of the photosensitive layer, and can suppress penetration of the developing solution into an exposed portion thereof.

Examples of the preferred nonionic surfactant, which is a necessary component of the developer composition, include such nonionic surfactants as a polyoxyethylene alkyl ether, a polyoxyethylene alkylphenyl ether, a polyoxyethylene polystyrylphenyl ether, a polyoxyethylene polyoxypropylene alkyl ether, a glycerin partial fatty acid ester, a sorbitan partial fatty acid ester, a pentaerythritol partial fatty acid ester, a propylene glycol fatty acid monoester, a sucrose partial fatty acid ester, a polyoxyethylene sorbitan partial fatty acid ester, a polyoxyethylene sorbitol partial fatty acid ester, a polyoxyethylene glycol fatty acid ester, a polyglycerin partial fatty acid ester, a polyoxyethylenated ricinus, a polyoxyethylene glycerin partial fatty acid ester, a fatty acid diethanolamide, an N,N-bis-2-hydroxyalkylamine, a polyoxyethylene alkylamine, a triethanolamine fatty acid ester and a trialkylamine oxide.

Among the foregoing surfactants, the term "polyoxyethylene" can be replaced by the term "polyoxyalkylene" which encompasses the meanings of "polyoxymethylene", "polyoxypropylene", "polyoxybutylene" and the like, and those surfactants containing the replaced terms are also preferable examples of the nonionic surface active agent. Specific examples of the nonionic surfactant include compounds represented by the following general formulae (1) to (8):

General Formula (1)

$$C_pH_{2p+1}-O(CH_2CH_2O)n(CH_2CH(CH_3)O)mH$$

General Formula (2)

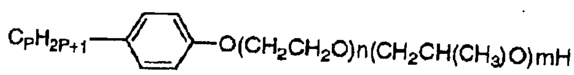

General Formula (3)

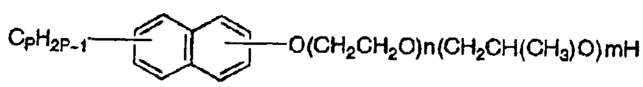

General Formula (4)

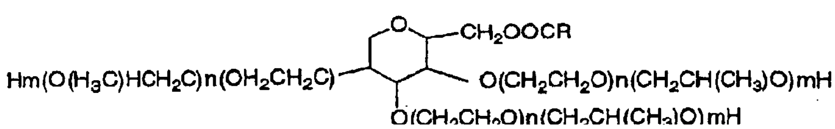

General Formula (5)

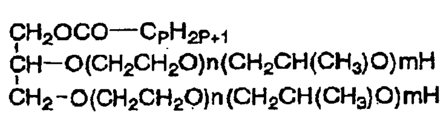

General Formula (6)

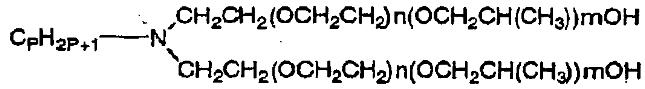

General Formula (7)

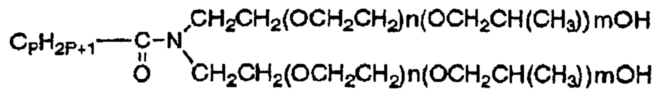

General Formula (8)

$$HO(CH_2CH_2O)n-(CH_2CH(CH_3)O)m-(CH_2CH_2O)_lH$$

wherein 1, m, n and p each represent an integer of 1 or greater.

As an index for determining more preferred nonionic surfactants among those represented by the general formulae, an "inorganicity/organicity value" described, for example, in *"Design of Emulsion Prescription by Organic Conceptual Diagrams"* by Y. Yamori, pp. 98 (1985) can be referred to. The inorganicity/organicity value is an index expressing an electrostatic nature of an organic compound, and those having a value in a range of from 0.9 to 3.0 are preferred. Among these, those in a range of from 1.1 to 2.5 are more preferred, and those in a range of from 1.3 to 2.0 are further preferred.

The relationship between specific structures of nonionic surfactants represented by the general formulae and the inorganicity/organicity values (I/O values) are shown in the following tables, but the invention is not limited thereto.

Naphthyl Surfactant (General Formula (1))

$$C_pH_{2p+1} - O(CH_2CH_2O)_n(CH_2CH(CH_3)O)_mH$$

Table 1

| Compound | p | n | m | I/O value |
|---|---|---|---|---|
| Example compound 1 | 0 | 5 | 0 | 1.34 |
| Example compound 2 | 8 | 5 | 0 | 0.96 |
| Example compound 3 | 0 | 13 | 0 | 1.58 |
| Example compound 4 | 0 | 20 | 0 | 1.66 |
| Example compound 5 | 0 | 28 | 0 | 1.71 |
| Example compound 6 | 0 | 5 | 5 | 0.91 |
| Example compound 7 | 0 | 13 | 10 | 1.01 |
| Example compound 8 | 0 | 28 | 10 | 1.28 |

R-Ph Surfactant (General Formula (2))

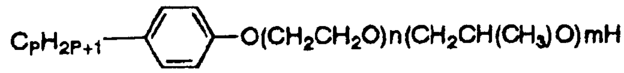

Table 2

| Compound | p | n | m | I/O value |
|---|---|---|---|---|
| Example compound 9 | 9 | 9 | 0 | 1.20 |
| Example compound 10 | 9 | 13 | 0 | 1.33 |
| Example compound 11 | 9 | 20 | 0 | 1.47 |
| Example compound 12 | 9 | 50 | 0 | 1.68 |
| Example compound 13 | 9 | 85 | 0 | 1.75 |
| Example compound 14 | 9 | 13 | 7 | 0.99 |
| Example compound 15 | 9 | 50 | 5 | 1.53 |

Alkyl Surfactant (General Formula (3))

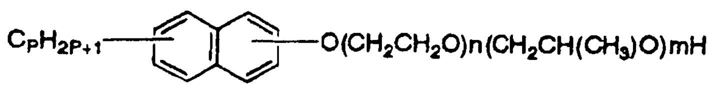

Table 3

| Compound | p | n | m | I/O value |
|---|---|---|---|---|
| Example compound 16 | 12 | 5 | 0 | 1.08 |
| Example compound 17 | 12 | 10 | 0 | 1.33 |
| Example compound 18 | 12 | 20 | 0 | 1.54 |
| Example compound 19 | 12 | 47 | 0 | 1.71 |
| Example compound 20 | 12 | 15 | 3 | 1.26 |
| Example compound 21 | 12 | 23 | 20 | 0.94 |
| Example compound 22 | 12 | 47 | 10 | 1.41 |

Sorbitan Ester Surfactant (General Formula (4))

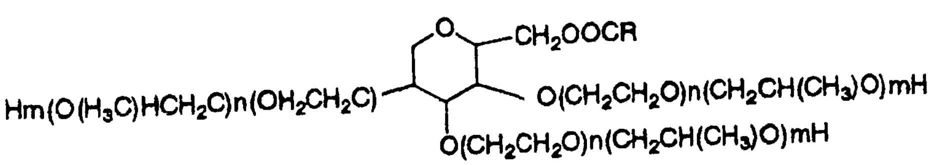

Table 4

| Compound | p | n | m | I/O value |
|---|---|---|---|---|
| Example compound 23 | 12 | 0 | 0 | 1.03 |
| Example compound 24 | 12 | 5 | 0 | 1.32 |
| Example compound 25 25 | 12 | 15 | 0 | 1.55 |
| Example compound 26 26 | 18 | 0 | 0 | 0.78 |
| Example compound 27 27 | 18 | 10 | 0 | 1.27 |
| Example compound 28 | 18 | 35 | 0 | 1.59 |
| Example compound 29 | 18 | 70 | 0 | 1.71 |

Glycerin Ester Surfactant (General Formula (5))

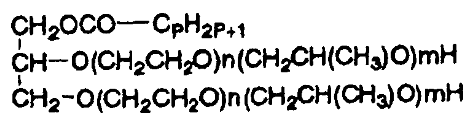

Table 5

| Compound | p | n | m | I/O value |
|---|---|---|---|---|
| Example compound 30 | 12 | 10 | 0 | 1.40 |
| Example compound 31 | 12 | 40 | 0 | 1.70 |
| Example compound 32 | 18 | 20 | 0 | 1.42 |
| Example compound 33 | 18 | 50 | 0 | 1.64 |

Diethanolamine Surfactant (General Formula (6))

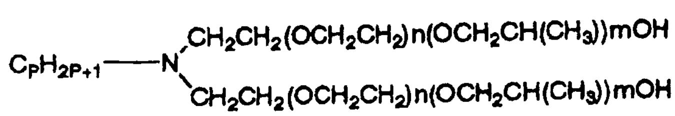

Table 6

| Compound | p | n | m | I/O value |
|---|---|---|---|---|
| Example compound 34 | 8 | 0 | 0 | 1.13 |
| Example compound 35 | 8 | 4 | 0 | 1.43 |
| Example compound 36 | 8 | 10 | 0 | 1.59 |
| Example compound 37 | 12 | 10 | 0 | 1.42 |

Table 6 (continued)

| Compound | p | n | m | I/O value |
|---|---|---|---|---|
| Example compound 38 | 12 | 20 | 0 | 1.58 |

Diethanolamide Surfactant (General Formula (7))

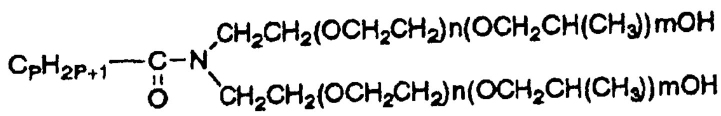

Table 7

| Compound | p | n | m | I/O value |
|---|---|---|---|---|
| Example compound 39 | 12 | 0 | 0 | 1.18 |
| Example compound 40 | 12 | 2 | 0 | 1.31 |
| Example compound 41 | 12 | 10 | 0 | 1.55 |
| Example compound 42 | 12 | 20 | 0 | 1.67 |

Pluronic Surfactant (General Formula (8))

$$HO(CH_2CH_2O)_n-(CH_2CH_2(CH_3)O)_m-(CH_2CH_2O)_lH$$

Table 8

| Compound | p | n | m | I/O value |
|---|---|---|---|---|
| Example compound 43 | 0 | 20 | 30 | 0.85 |
| Example compound 44 | 0 | 30 | 30 | 1.17 |
| Example compound 45 | 0 | 80 | 30 | 1.34 |
| Example compound 46 | 0 | 30 | 100 | 0.60 |
| Example compound 47 | 0 | 200 | 100 | 1.22 |
| Example compound 48 | 0 | 400 | 100 | 1.46 |

In order to exhibit subsidiary functions, other surfactants in addition to the nonionic surfactant may be added in such amounts as do not impair the effect of the invention. Examples of the surfactants that can be used in combination with the nonionic surfactant include an anionic surfactant, a cationic surfactant, an amphoteric surfactant and combinations thereof.

More specific examples of these surfactants include anionic surfactants such as a fatty acid salt, an abietic acid salt, a hydroxyalkane sulfonate, an alkane sulfonate, a dialkylsulfosuccinate ester, a linear alkylbenzene sulfonate, a branched alkylbenzene sulfonate, an alkylnaphthalene sulfonate, an alkylphenoxypolyoxyethylene propyl sulfonate, a polyoxyethylene alkylsulfophenyl ether, sodium N-methyl-N-oleyltaurine, a sodium N-alkylsulfosuccinic monoamide, a petroleum sulfonate, sulfonated ricinus, sulfonated beef tallow, a sulfate ester of a fatty alkyl ester, an alkyl sulfate ester, a polyoxyethylene alkyl ether sulfate ester, a fatty acid monoglyceride sulfate ester, a polyoxyethylene alkylphenyl

ether sulfate ester, a polyoxyethylene styrylphenyl ether sulfate ester, an alkyl phosphate ester, a polyoxyethylene alkyl ether phosphate ester, a polyoxyethylene alkylphenyl ether phosphate ester, a partially saponified product of a styrene-maleic anhydride copolymer, a partially saponified product of an olefin-maleic anhydride copolymer and a naphthalenesulfonate-formalin condensate; cationic surfactants, such as an alkylamine, a quaternary ammonium salt, a polyoxyethylene alkylamine salt and a polyethylene polyamine derivative; and an amphoteric surfactants, such as a carboxybetaine, an aminocarboxylic acid, a sulfobetain, an aminosulfate ester and a imidazoline compound. A plurality of these compounds may be used in combination.

An amount of the nonionic surfactant is preferably from 0.2 to 30% by weight, and more preferably from 0.3 to 15% by weight, based on the amount of the developer composition. When the amount of the nonionic surfactant is less than 0.2% by weight, there is a possibility of contamination in the non-image portion, whereas when the amount exceeds 30% by weight, there is a tendency for lower printing durability, and neither case is preferred.

Known additives may be used in combination in the developer composition as necessary in such amounts that the effect of the invention is not impaired. Examples of the known additives include reducing agents, such as hydroquinone, resorcin, sulfurous acid, and a sodium salt and a potassium salt of an inorganic acid, such as a bisulfite, an organic carboxylic acid, a defoaming agent, and a water softening agent.

However, an organic solvent, such as benzyl alcohol, may affect printing durability, and it is therefore preferred that the developer composition contains substantially no organic solvent even though it is an additive for accelerating development.

In a case where development is carried out using an automatic developing machine, it is known that by adding an aqueous solution (replenisher) having a higher alkaline intensity than a developing solution, a large number of lithographic printing plates can be processed without changing the developing solution in a developing tank for a long period of time. The replenishing method is preferably applied to the present invention, and the aqueous solution used as the replenisher preferably has a pH level in a range of from 9 to 14, and more preferably in a range of from 10 to 13.

In the present invention, the developer composition and a process for forming an image using the developer composition are applied to a negative image forming material formed by providing, on a support, a recording layer containing an infrared ray absorbent, a radical generator and a radically polymerizable compound.

The negative image forming material will now be described. The image forming material has a recording layer, as a photosensitive layer, containing an infrared ray absorbent, a radical generator and a radically polymerizable compound, and in order to improve the film properties of the recording layer, it is preferable that the recording layer further contains a binder polymer.

An image portion is formed on the image forming material by imagewise exposure to an infrared laser in the following manner. The infrared ray absorbent in an exposed portion of the recording layer undergoes a photothermal conversion, and the radical generator is decomposed by the thus formed heat to generate radicals. The radically polymerizable compound is cured by the radicals through a polymerization reaction, and a reaction between the binder polymer, which is added as necessary, and the radically polymerizable compound is also caused, whereby curing of the exposed portion results in forming an image. Thereafter, development is carried out with a weak alkaline aqueous solution, i.e., the developer composition of the present invention, to remove an unexposed portion of the recording layer, which is uncured, thereby forming a non-image portion.

The respective components included in the recording layer of a lithographic printing plate (i.e., the image forming material), to which the developer composition and the process for forming an image of the present invention can be preferably applied, will be described below.

(A) Infrared Ray Absorbent

The recording layer of the original lithographic printing plate of the present invention necessarily contains the infrared ray absorbent having such a function that an absorbed infrared ray is converted to heat in order to carry out image formation with a laser emitting an infrared ray. The radical generator is decomposed by the heat thus generated to form radicals. The infrared ray absorbent used in the present invention comprises a dye or a pigment having an absorption maximum at a wavelength of from 760 to 1,200 nm.

As the dye, commercially available dyes and known dyes disclosed, for example, in *"Senryo Binran"* (*Dyes Handbook*), edited by the Society of Synthetic Organic Chemistry, Japan (1970) can be utilized. Specific examples thereof include dyes, such as azo dyes, metallic complex azo dyes, pyrazolone azo dyes, naphthoquinone dyes, anthraquinone dyes, phthalocyanine dyes, carbonium dyes, quinoneimine dyes, methine dyes, cyanine dyes, squalirium coloring matters, pyrylium salts and metallic thiolate complexes.

Preferred examples of the dye include cyanine dyes disclosed in Japanese Patent Application Laid-open (JP-A) Nos. 58-125246, 59-84356, 59-202829 and 60-78787, methine dyes disclosed in JP-A Nos. 58-173696, 58-181690 and 58-194595, naphthoquinone dyes disclosed in JP-A Nos. 58-112793, 58-224793, 59-48187, 59-73996, 60-52940 and 60-63744, squalirium dyes disclosed in JP-A

No. 58-112792, and cyanine dyes disclosed in British Patent No. 434,875.

A near infrared ray absorbing sensitizer disclosed in USP No. 5,156,938 can also be preferably used. Substituted arylbenzo(thio)pyrylium salts disclosed in USP No. 3,881,924, trimethinethiapyrylium salts disclosed in JP-A No. 57-142645 (USP No. 4,327,169), pyrylium compounds disclosed in JP-A Nos. 58-181051, 58-220143, 59-41363, 59-84248, 59-84249, 59-146063 and 59-146061, cyanine coloring matters disclosed in JP-A No. 59-216146, pentamethinethiopyrylium salts disclosed in USP No. 4,283,475, and pyrylium compounds disclosed in JP-B Nos. 5-13514 and 5-19702 can also be preferably used.

Further preferred examples of the dye include near infrared ray absorbing dyes disclosed as formulae (I) and (II) in USP No. 4,756,993.

Particularly preferred examples among these dyes include cyanine dyes, squalirium dyes, pyrylium salts and nickel thionate complexes, and among, and a cyanine dye represented by the following general formula (I) is most preferred.

General formula (I)

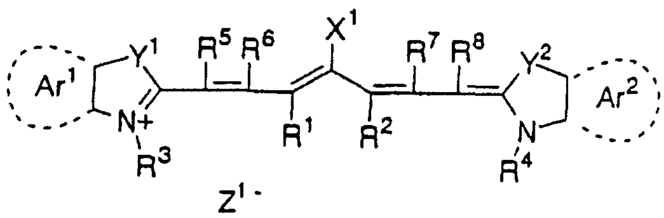

In the general formula (I), $X^1$ represents a halogen atom or $X^2$-$L^1$. $X^2$ herein represents an oxygen atom or a sulfur atom, and $L^1$ represents a hydrocarbon group having from 1 to 12 carbon atoms. $R^1$ and $R^2$ each independently represents a hydrocarbon group having from 1 to 12 carbon atoms, which is preferably a hydrocarbon group having 2 or more carbon atoms from a standpoint of a storage stablility of a coating composition for the photosensitive layer. Particularly preferably, $R^1$ and $R^2$ are bonded to each other to form a 5-membered or 6-membered ring.

$Ar^1$ and $Ar^2$, which may be the same or different, each represent an aromatic hydrocarbon group, which may have a substituent. Preferred examples of the aromatic hydrocarbon group include a benzene ring and a naphthalene ring. Preferred examples of the substituent include a hydrocarbon group having no greater than 12 carbon atoms, a halogen atom and an alkoxy group having no greater than 12 carbon atoms. $Y^1$ and $Y^2$, which may be the same or different, each represent a sulfur atom or a dialkylmethylene group having no greater than 12 carbon atoms. $R^3$ and $R^4$, which may be the same or different, each represent a hydrocarbon group having no greater than 20 carbon atoms, which may have a substituent. Preferred examples of the substituent include an alkoxy group, a carboxyl group and a sulfo group having no greater than 12 carbon atoms. $R^5$, $R^6$, $R^7$ and $R^8$, which may be the same or different, each represent a hydrogen atom or a hydrocarbon group having no greater than 12 carbon atoms. They are preferably hydrogen atoms from a standpoint of availability of the materials. $Z^{1-}$ represents a counter anion. In the case where a sulfo group is substituted in one of $R^1$ to $R^8$, $Z^{1-}$ may not be present. Preferred examples of $Z^{1-}$ include a halogen ion, a perchlorate ion, a tetrafluoroborate ion, a hexafluorophosphate ion and a sulfonate ion from a standpoint of storage stability of the coating composition for the photosensitive layer, and particularly preferred examples thereof include a perchlorate ion, a hexafluorophosphate ion and an arylsulfonate ion.

Specific examples of the cyanine dye represented by the general formula (I), which are preferably used in the invention, include those disclosed in paragraphs (0017) to (0019) of Japanese Patent Application No. 11-310623.

As the pigment used in the present invention, commercially available pigments and pigments disclosed in *"Color Index (C.I.) Handbook", "Saishin Ganryo Binran" (Newest Pigments Handbook*), edited by the Association of Pigment Technologies, Japan (1977), *"Saishin Ganryo Oyo Gijutu" (Newest Pigment Application Technique*), published by CMC Press (1986), and *"Insatu Inki Gijutu" (Printing Ink Technique),* published by CMC Press (1984) can be utilized.

Examples of kinds of the pigments include a black pigment, a yellow pigment, an orange pigment, a brown pigment, a red pigment, a violet pigment, a blue pigment, a green pigment, a fluorescent pigment, a metallic powder pigment and a polymer bound pigment. Specific examples thereof include insoluble azo pigments, azo lake pigments, condensed azo pigments, chelate azo pigments, phthalocyanine pigments, anthraquinone pigments, perylene and perynone pigments, thioindigo pigments, quinacridone pigments, dioxane pigments, isoindolinone pigments, quinophthalone pigments, dying lake pigments, azine pigments, nitroso pigments, nitro pigments, natural pigments, fluorescent pigments, inorganic pigments and carbon black. Among these pigments, carbon black is preferred.

These pigments may be used without a surface treatment or may be used after application of a surface treatment. Examples of methods for applying the surface treatment include a coating the surface with a resin or wax, attaching a surfactant, and bonding a reactive substance (such as a silane coupling agent, an epoxy compound or a

polyisocyanate) to the surface of the pigment. The methods for applying the surface treatment are disclosed in *"Kinzoku Sekken no Seishitu to Oyo" (Natures and Applications of Metallic Soap),* published by Saiwai Shobo, *"Insatu Ink Gijutu" (Printing Ink Technique),* published by CMC Press (1984), and *"Saishin Ganryo Oyo Gijutu"* (*Newest Pigment Application Technique*), published by CMC Press (1986).

A particle diameter of the pigment is preferably in a range of from 0.01 to 10 μm, more preferably in a range of from 0.05 to 1 μm, and particularly preferably in a range of from 0.1 to 1 μm. When the particle diameter of the pigment is less than 0.01 μm, it is not preferred from a standpoint of stability of matter dispersed in the coating composition for the photosensitive layer, whereas when it exceeds 10 μm, it is not preferred from the standpoint of uniformity of a photosensitive layer.

As a method for dispersing the pigment, known dispersion techniques used in production of inks and toners can be utilized. Examples of a disperser include an ultrasonic wave disperser, a sand mill, an attritor, a pearl mill, a super mill, a ball mill, an impeller, a disperser, a KD mill, a colloid mill, a dynatron, a three-roll mill and a pressure kneader. Details thereof are disclosed in *"Saishin Ganryo Oyo Gijutu" (Newest Pigment Application Technique) ,* published by CMC Press (1986).

The infrared ray absorbent preferably has an optical density within a range of from 0.1 to 3.0 at an absorption maximum at a wavelength within a range of from 760 to 1,200 nm in the photosensitive layer upon producing the original negative lithographic printing plate. When the optical density deviates from the range, there is a tendency for sensitivity to be lowered. Because the optical density is determined by the amount of the infrared ray absorbent and a thickness of the recording layer, the prescribed optical density can be obtained by controlling both of these parameters. The optical density of the recording layer can be measured by an ordinary method. One example thereof is a method in which a recording layer is formed on a transparent or white support, with a coating amount after drying corresponding to a thickness appropriately determined in a range necessary for the lithographic printing plate, and the optical density is measured with a transmission optical densitometer, and another example is a method in which a recording layer is formed on a reflective support, such as aluminum, and the reflective density is measured.

(B) Radical Generator

The radical generator contained in the recording layer of the lithographic printing plate in the invention is used in combination with the infrared ray absorbent and generates radicals upon irradiation with an infrared laser. Examples of the radical generator include an onium salt, a triazine compound having a trihalomethyl group, a peroxide, an azo polymerization initiator, an azide compound and a quinone diazide, and an onium salt is preferred owing to its high sensitivity.

An onium salt, which can be preferably used as a radical polymerization initiator in the invention, will now be described. Preferred examples of the onium salt include an iodonium salt, a diazonium salt and a sulfonium salt. In the invention, these onium salts do not function as an acid generator but function as an initiator of radical polymerization. Preferred examples of the onium salt used in the invention include those represented by the following general formulae (III) to (V).

Formula (III) $$Ar^{11}-\overset{+}{I}-Ar^{12} \quad Z^{11-}$$

Formula (IV) $$Ar^{21}-\overset{+}{N}\equiv N \quad Z^{21-}$$

Formula (V) 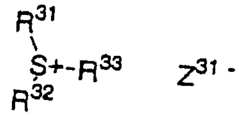

In the formula (III), $Ar^{11}$ and $Ar^{12}$ each independently represents an aryl group having no greater than 20 carbon atoms, which may have a substituent. In a case where the aryl group has a substituent, preferred examples of the substituent include a halogen atom, a nitro group, an alkyl group having no greater than 12 carbon atoms, an alkoxy group having no greater than 12 carbon atoms and an aryloxy group having no greater than 12 carbon atoms. $Z^{11-}$ represents a counter ion selected from a halogen ion, a perchlorate ion, a tetrafluoroborate ion, a hexafluoroborate ion and a sulfonate ion, and preferred examples thereof include a perchlorate ion, a hexafluoroborate ion and an arylsulfonate ion.

In the formula (IV), $Ar^{21}$ represents an aryl group having no greater than 20 carbon atoms, which may have a substituent. Preferred examples of the substituent include a halogen atom, a nitro group, an alkyl group no greater than 12 carbon atoms, an alkoxy group no greater than 12 carbon atoms, an aryloxy group no greater than 12 carbon atoms, an alkylamino group no greater than 12 carbon atoms, a dialkylamino group no greater than 12 carbon atoms, an arylamino group no greater than 12 carbon atoms and a diarylamino group no greater than 12 carbon atoms. $Z^{21-}$ represents a counter ion having the same characteristics as $Z^{11-}$. In the formula (V) , $R^{31}$, $R^{32}$ and R33, which may be the same or different, each represent a hydrocarbon group no greater than 20 carbon atoms, which may have a substituent. Preferred examples of the substituent include a halogen atom, a nitro group, an alkyl group no greater than 12 carbon atoms, an alkoxy group no greater than 12 carbon atoms and an aryloxy group no greater than 12 carbon atoms. $Z^{31-}$ represents a counter ion having the same characteristics as $Z^{11-}$. Specific examples of the onium salt that can be preferably used as the radical generator in the invention include those disclosed in paragraphs [0030] to [0033] of Japanese Patent Application No. 11-310623. The radical generator used in the invention preferably has a maximum absorption wavelength of no greater than 400 nm, and more preferably no greater than 360 nm. When the maximum absorption wavelength is in the range of an ultraviolet ray, the original lithographic printing plate can be handled in roomlight.

The radical generator can be added to a coating composition for forming the photosensitive layer in an amount of from 0.1 to 50% by weight, preferably from 0.5 to 30% by weight, and particularly preferably from 1 to 20% by weight, based on a total solid content of the coating composition. When the added amount is less than 0.1% by weight, sensitivity is low, whereas when it exceeds 50% by weight, contamination occurs in the non-image portion upon printing. The radical generator may be used singly, or two or more kinds thereof may be used in combination. The radical generator may be added to the same layer as the other components or may be added to a layer that is separately provided.

(C) Radically Polymerizable Compound

The radically polymerizable compound used in the recording layer in the invention has at least one ethylenic unsaturated double bond, and can be selected from compounds having at least one, and preferably no less than two, end ethylenic unsaturated bonds. The compounds are widely known in this field of art, and they can be used in the invention without any particular limitation. They have various chemical forms, such as that of a monomer, a prepolymer, (i.e., a dimer or a trimer,) and an oligomer, a mixture thereof and a copolymer thereof. Examples of the monomer and the copolymer thereof include an unsaturated carboxylic acid (such as acrylic acid, methacrylic acid, itaconic acid, crotonic acid, isocrotonic acid and maleic acid), an ester thereof, and an amide thereof, and an ester of an unsaturated carboxylic acid and an aliphatic polyvalent alcohol, and amide of an unsaturated carboxylic acid and an aliphatic polyvalent amine compound are preferably used. An addition reaction product of an unsaturated carboxylate ester or amide having a nucleophilic substituent group, such as a hydroxyl group, an amino group and a mercapto group, with a monofunctional or polyfunctional isocyanate or epoxy compound, and a dehydration condensation reaction product with a monofunctional or polyfunctional carboxylic acid can also be preferably used. An addition reaction product of an unsaturated carboxylate ester or amide having an electrophilic substituent group, such as an isocyanate group and an epoxy group, with a monofunctional or polyfunctional alcohol, amine or thiol, and a substitution reaction product of an unsaturated carboxylate ester or amide having a releasing substituent group, such as a halogen atom and a tosyloxy group, with a monofunctional or polyfunctional alcohol, amine or thiol can also be preferably used. Other usable examples thereof include compounds formed by replacing the unsaturated carboxylic acid in the foregoing compounds with an unsaturated phosphonic acid or styrene.

Specific examples of an acrylate ester, a methacrylate ester, an itaconate ester, a crotonate ester, an isocrotonate ester and a maleate ester, which is an ester of an aliphatic polyvalent alcohol and an unsaturated carboxylic acid as the radically polymerizable compound, are disclosed in paragraphs (0037) to (0042) of Japanese Patent Application No. 11-310623, and can be used in the present invention.

Other examples of the esters include aliphatic alcohol esters disclosed in JP-B Nos. 46-27926 and 51-47334 and JP-A No. 57-196231, compounds having an aromatic skeleton disclosed in JP-A Nos. 59-5240, 59-5241 and 2-226149, and compounds containing an amino group disclosed in JP-A No. 1-165613.

Specific examples of the monomers of an amide of an aliphatic polyvalent amine and an unsaturated carboxylic acid include methylenebis-acrylamide,
methylenebis-methacrylamide,
1,6-hexamethylenebis-acrylamide,
1,6-hexamethylenebis-methacrylamide,
diethylenetriaminetrisacrylamide, xylylenebisacrylamide and xylylenebismethacrylamide.

Other preferred examples of the amide monomers include those having a cyclohexylene structure disclosed in JP-B No. 54-21726.

A urethane addition polymerizable compound produced by an addition reaction of an isocyanate and a hydroxyl group is also preferred, and specific examples thereof include a vinylurethane compound containing no less than two polymerizable vinyl groups in one molecule formed by adding a vinyl monomer having a hydroxyl group represented by the following formula (VI) to a polyisocyanate compound having no less than two isocyanate groups in one molecule disclosed in JP-B No. 48-41708.

$$CH_2=C(R^{41})COOCH_2CH(R^{42})OH \qquad (VI)$$

In the formula (VI), $R^{41}$ and $R^{42}$ each represent H or $CH_3$.

Urethane acrylates disclosed in JP-A No. 51-37193 and, JP-B Nos. 2-32293 and 2-16765, and urethane compounds having an ethylene oxide skeleton disclosed in JP-B Nos. 58-49860, 56-17654, 62-39417 and 62-39418 are also preferred.

Furthermore, radically polymerizable compounds having an amino structure or a sulfide structure in a molecule disclosed in JP-A Nos. 63-277653, 63-260909 and 1-05238 may also be used.

Other examples thereof include polyfunctional acrylates and methacrylates, such as polyester acrylates and epoxy acrylates formed by reacting an epoxy resin and (meth)acrylic acid disclosed in JP-A No. 48-64183 and JP-B Nos. 49-43191 and 52-30490. Further examples thereof include particular unsaturated compounds disclosed in JP-B Nos. 46-43946, 1-40337 and 1-40336, and vinylsulfone compounds disclosed in JP-A No. 2-25493. In some cases, structures containing a perfluoroalkyl group disclosed in JP-A No. 61-22048 are preferably used. Moreover, those shown as a photocurable monomer or oligomer in *"Nippon Secchaku Kyoukai-shi"* (*Journal of the Adhesion Society of Japan*), vol. 20, No. 7, pp. 300 to 308 (1984) can be used.

Details of a method for using the radically polymerizable compound, e.g., a structure thereof, single use or combination use and an amount tobe added, can be arbitrarily determined depending on a final performance specifications of the recording material. For example, these factors can be determined from the following standpoints. A structure having a large number of an unsaturated group per molecule is preferred from a standpoint of sensitivity, and a compound having two or more kinds of functionality is preferred in many cases. In order to improve the strength of the image portion, i.e., the cured film, a compound having three or more kinds of functionality is preferred, and it is also effective if both sensitivity and strength are adjusted by using a combination of compounds having different numbers of kinds of functionality and different kinds of polymerizable groups (for example, an acrylate ester compound, a methacrylate ester compound and a styrene compound) . A compound having a large molecular weight and a compound having high hydrophobicity are excellent in sensitivity and film strength, whereas there are some cases where they are not preferred from a standpoint of development rate and deposition in the developing solution. The selection of and method for using the radically polymerizable compound are also important factors for dispersibility and compatibility with the other components in the photosensitive layer (for example, the binder polymer, the initiator and the coloring agent), and for example, there are cases where compatibility can be improved by using a compound of low purity or a combination of two or more kinds of compounds. It is also possible that a particular structure can be selected to improve adhesion to a support or an overcoating layer. When a mixing ratio of the radically polymerizable compound in the image recording layer is large, sensitivity can be improved, but when it is too large, undesired phase separtion is likely to occur, or it may cause problems in a production process due to adhesiveness of the image recording layer (for example, production failure due to transfer and adherence of the components of the recording layer) and problems such as deposition from the developing solution. In light of these considerations, the mixing ratio of the radically polymerizable compound is generally from 5 to 80% by weight, and preferably from 20 to 75% by weight, based on the total composition in many cases. The radically polymerizable compound may be used solely or two or more kinds thereof in combination. With respect to the method for using the radically polymerizable compound, factors including the structure, the mixing ratio and the amount to be added can be arbitrarily determined, and as is suitable from the standpoints of an extent of polymerization hindrance due to oxygen, a resolution, a fogging properties, refractive index change and surface adherence. In some cases, layer structuring and coating methods such as undercoating and overcoating can also be carried out.

(D) Binder Polymer

The recording layer of the present invention preferably contains a binder polymer from the standpoint of improving film properties. A linear organic polymer is preferably used as the binder, and any kind thereof can be used. Preferably, a linear organic polymer that is soluble or swellable in water or a weak alkaline aqueous solution is selected in order to realize water development or weak alkaline aqueous solution development. The linear organic polymer is selected used not only for its utility as a film forming agent for forming the photosensitive layer, but also for its compatibility with developing agents such as water, a weak alkaline aqueous solution or an organic solvent. For example, water development can be carried out when a water soluble organic polymer is used. Examples of the linear organic polymer include a radical polymer having a carboxylic acid group on a side chain thereof, such as those disclosed in JP-B Nos. 54-34327, 58-12577, 54-25957, and JP-ANos. 59-44615, 54-92723, 59-53836 and 59-71048, i.e., a methacrylic acid copolymer, an acrylic acid copolymer, an itaconic acid copolymer, a crotonic acid copolymer, a maleic acid copolymer and a partially esterified maleic acid copolymer. Further examples thereof include an acidic cellulose derivative having a carboxylic acid group on a side chain thereof. Other useful examples thereof include a product obtained by adding a cyclic acid anhydride to a polymer having a hydroxyl group.

Among these, a (meth) acrylic resin having a benzyl group or an allyl group, and a carboxyl group on a side chain thereof is particularly preferred since it is excellent in balance among film strength, sensitivity and development properties.

Urethane binder polymers having an acid group disclosed in JP-B Nos. 7-12004, 7-120041, 7-120042, and 8-12424, JP-A Nos. 63-287944, 63-287947, and 1-271741 and Japanese Patent Application No. 10-116232 are advantageous in printing durability and suitability for low exposure because they are considerably excellent in strength.

Polyvinyl pyrrolidone and polyethylene oxide are also useful as the water soluble linear organic polymer, and in order to improve the strength of the cured film, alcohol soluble nylon and a polyether of 2,2-bis(4-hydroxyphenyl) propane and epichlorohydrin are useful.

A weight average molecular weight of the binder polymer used in the invention is preferably no less than 5,000, and more preferably in a range of from 10,000 to 300,000, and a number average molecular weight thereof is preferably no less than 1,000, and more preferably in a range of from 2,000 to 250,000. The polydispersibility (weight average molecular weight/number average molecular weight) of the polymer is preferably no less than 1, and more preferably in a range of from 1.1 to 10.

These polymers may be a random polymer, a block polymer or a graft polymer, and are preferably a random polymer.

The binder polymer used in the invention may be used singly or as a mixture of two or more thereof. The polymer is added to the photosensitive layer generally in an amount of from 20 to 95% by weight, and preferably from 30 to 90% by weight, based on the total solid content of the coating composition for the recording layer. When the added amount is less than 20% by weight, the strength of the image portion becomes insufficient upon image formation. When the added amount exceeds 95% by weight, image formation results in failure. The ratio of the radically polymerizable compound having an ethylenic unsaturated double bond and the linear organic polymer is preferably in a range of from 1/9 to 7/3 by weight.

Other Components in the Photosensitive Layer

In the invention, other kinds of compounds may be added as necessary. For example, a dye having high absorption in the visible light range can be used as a coloring agent for the image. In order to prevent unnecessary thermal polymerization of the radically polymerizable compound, having an ethylenic unsaturated double bond, during preparation or storage of the coating composition for forming the recording layer, it is preferable to add a small amount of a thermal polymerization inhibitor.

Nonionic surfactants disclosed in JP-A Nos. 62-251740 and 3 - 208514 and amphoteric surfactants disclosed in JP-A Nos. 59-121044 and 4-13149 may be added to the coating composition for forming the recording layer of the invention in order to stabilize processing with respect to development conditions.

Furthermore, a plasticizer may be added as necessary to the coating composition for forming the photosensitive layer to impart flexibility to the coated film. Examples thereof include polyethylene glycol, tributyl citrate, diethyl phthalate, dibutyl phthalate, dihexyl phthalate, dioctyl phthalate, tricresyl phosphate, tributyl phosphate, trioctyl phosphate and tetrahydrofurfuryl oleate.

In order to produce the original lithographic printing plate of the invention, the above-described components necessary for the coating composition for forming the photosensitive layer are generally dissolved in a solvent and coated on an appropriate support. Examples of the solvent used herein include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the solvent is not limited thereto. The solvents may be used singly or as a mixture. A concentration of the above-described components (i.e., the total solid content of the coating composition including additives) in the solvent is preferably from 1 to 50% by weight.

In general, a coated amount (solid content) of the photosensitive layer on the support after drying is preferably, from 0.5 to 5.0 g/m$^2$ for an original lithographic printing plate while this amount may vary according to specific objectives. Various coating methods can be utilized, and usable examples thereof include bar coater coating, spin coating, spray coating, curtain coating, dip coating, air knife coating, blade coating and roll coating. When the amount of coating is smaller, apparent sensitivity is increased, but film characteristics of the photosensitive layer undergoing image recording are degraded.

In the coating composition forforming the photosensitive layer of the present invention, a surfactant, such as fluorine surfactants disclosed in JP-A No. 62-170950, may be added to improve coating properties. The amount thereof is preferably from 0.01 to 1 % by weight, and more preferably from 0.05 to 0.5% by weight, based on the total solid content of the photosensitive layer.

Support

The negative image forming material used in the method of the present invention is formed by coating the photosensitive layer on a support. The support used herein is not particularly limited as long as it is a dimensionally stable article having a plate form, and examples thereof include paper, paper having plastics (such as polyethylene, polypropylene and polystyrene) laminated thereon, a metallic plate (such as aluminum, zinc and copper), a plastic film (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinylacetal), and paper or a plastic film having the foregoing metals laminated or vapor-deposited thereon. Preferred examples of the support include a polyester film and an aluminum plate.

As the support used in the original lithographic printing plate of the invention, an aluminum plate is preferably used, which has a light weight and is excellent in surface treatment properties, workability and corrosion resistance. Examples of aluminum materials used therefor include an Al-Mg alloy, an Al-Mn alloy, an Al-Mn-Mg alloy, an Al-Zr alloy, an Al-Mg-Si alloy, and JIS 1050 material that contains no less than 99.5 %wt of aluminum, 0.30 %wt of Fe, 0.10 %wt of Si, 0.02 %wt of Ti and 0.013%wt of Cu.

Preferred examples of the aluminum plate include a pure aluminum plate and an alloy plate containing aluminum as a main component having slight amounts of foreign elements as described in the foregoing, and a plastic film having aluminum laminated or vapor-deposited thereon may also be used. Examples of the foreign elements contained in the aluminum alloy include silicon, iron, manganese, copper, magnesium, chromium, zinc, bismuth, nickel and titanium. A content of the foreign elements in the alloy is no greater than 10% by weight. While pure aluminum is preferred as the aluminum plate, materials having slight amounts of foreign elements may be used because completely pure aluminum is difficult to produce by refining techniques. Therefore, the aluminum plate is not limited with regards to a composition thereof, and aluminum plates formed with known materials can be appropriately used. A thickness of the aluminum plate is preferably from about 0.1 to 0.6 mm, more preferably from about 0.15 to 0.4 mm, and particularly preferably from about 0.2 to 0.3 mm.

Before subjecting the aluminum plate to a surface roughening treatment, a degreasing treatment for removing a rolling oil from the surface thereof may be carried out as necessary by using, for example, a surfactant, an organic solvent or an alkaline aqueous solution.

The surface roughening treatment for the aluminum plate can be carried out by various methods, and examples thereof include a method of mechanically roughening the surface, a method of electrochemically dissolving and roughening the surface, and a method of chemically and selectively dissolving the surface. Examples of mechanical methods that can be used in the invention include various known methods, such as a ball grinding method, a brush grinding method, a blast grinding method and a buff grinding method. Examples of electrochemical methods include roughening the surface of the plate in a hydrochloric acid or nitric acid electrolyte with alternating current or direct current.

The aluminum plate thus roughened is subjected to an alkali etching treatment and a neutralizing treatment as necessary, and then subjected to an anodic oxidation treatment as necessary for improving water holding properties and abrasion resistance of the surface. An amount of an anodic oxidized film formed by anodic oxidation is preferably no less than 1.0 g/m$^2$. When the amount of the anodic oxidized film is less than 1.0 g/m$^2$, printing durability becomes insufficient, and if the plate is used as a lithographic printing plate, the non-image portion is liable to be damaged, whereby so-called "flaw marks" tend to be formed as ink adheres to the damaged parts upon printing.

After undergoing to the anodic oxidation treatment, the surface of the aluminum plate is subjected to a hydrophilic treatment as necessary.

After undergoing to the anodic oxidation treatment, the aluminum support may also be subjected to a treatment via an organic acid or a salt thereof or receive an undercoating layer for coating the photosensitive layer.

The support for the lithographic printing plate preferably has a center line average roughness of from 0.10 to 1.2 μm. When it is lower than 0.10 μm, adhesiveness with respect to the photosensitive layer is decreased causing considerable reduction in printing durability. When it exceeds 1.2 μm, there is a greater chance of contamination upon printing. A color density of the support preferably corresponds to a reflactive density of from 0.15 to 0.65. When it is whiter than 0.15, halation upon imagewise exposure is too strong and thus causing problems with respect to image formation, and when it is blacker than 0.65, an image thus formed is difficult to view after development causing considerable problems with respect to plate inspection.

An intermediate layer may be provided to improve adhesiveness between the support and the photosensitive layer. In order to improve the adhesiveness, the intermediate layer generally comprises a diazo resin or a phosphoric acid compound adhered to aluminum. A thickness of the intermediate layer may be arbitrarily determined but is necessarily such a thickness that, upon exposure, a uniform bond forming reaction is carried out between the intermediate layer and the photosensitive layer. In general, A coating amount is preferably about from 1 to 100 mg/m$^2$, and more preferably from 5 to 40 mg/m$^2$, in terms of dry solid content. A usage ratio of the diazo resin within the intermediate layer is generally from 30 to 100%, and preferably from 60 to 100%.

After subjecting the surface of the support to the treatments and undercoating described above, a coating is provided on a back surface of the support as necessary. As the back coating, an organic polymer compound disclosed in JP-A No. 5-45885 and a coating layer formed with a metallic oxide obtained by hydrolysis and polycondensation of an organic or inorganic metallic compound disclosed in JP-A No. 6-35174 can be preferably used.

Protective Layer

In the original lithographic printing plate of the present invention, a protective layer may be formed as necessary on the recording layer containing the photopolymerizable compound. The original lithographic printing plate is generally subjected to exposure in the open air, and the protective layer prevents invasion of low molecular weight compounds present in air, such as oxygen and basic substances, that inhibit the image formation reaction caused in the photosensitive layer by exposure, whereby inhibition of the image forming reaction by exposure in the air is prevented. Therefore, the protective layer is expected to have the following characteristics. That is, permeability of low molecular weight compounds, such as oxygen, is low, transmission properties with respect to light used for exposure is good, adhesiveness with respect to the photosensitive layer is good, and it can be easily removed via developing after exposure.

Various proposals have been made for such a protective layer and are disclosed in detail in USP No. 3,458,311 and JP-A No. 55-49729. Preferred examples of materials that can be used in the protective layer include water soluble polymer compounds that have a relatively high crystallinity. Specifically, water soluble polymers, such as polyvinyl alcohol, polyvinyl pyrrolidone, an acidic cellulose, gelatin, gum arabic and polyacrylic acid, are known, and among these, those having polyvinyl alcohol as a main component provide the best results for the basic characteristics of the protective layer, such as oxygen shielding and removability via development. The polyvinyl alcohol used in the protective layer may be partially substituted with an ester, an ether or an acetal, as long as it contains a sufficient amount of an unsubstituted vinyl alcohol unit for attaining the necessary oxygen shielding and water solubility. It similarly may partially contain other copolymerization components.

Examples of the polyvinyl alcohol include those being hydrolyzed in a ratio of from 71 to 100% and having a molecular weight of from 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (trade names: produced by Kuraray Co., Ltd.).

A composition (PVA selection and additive use) and a coated amount of the protective layer may be selected taking into consideration fogging properties, adhesion and flaw resistance, as well as oxygen shielding and removability via development. In general, when a hydrolysis ratio of the PVA used is higher (i.e., when a content of the unsubstituted vinyl alcohol unit in the protective layer is larger), and when a thickness of the layer is greater, better oxygen shielding

is attained, and thus these conditions are advantageous from a standpoint of sensitivity. However, when an oxygen shielding capacity is too high, problems are caused, such as occurance of an unnecessary polymerization reaction upon production and during storage before use, and unnecessary fogging and thickening of line images upon imagewise exposure. Adhesion with respect to the image portion and flaw resistance property are also considerably important from a standpoint of handling of the printing plate. That is, when a hydrophilic layer comprising a water soluble polymer is accumulated on an oleophilic polymerized layer, film release due to poor adhesive strength is liable to occur, whereby defects are caused, such as film curing failure on the released portion due to polymerization inhibition with oxygen.

Various proposals have been made to improve the adhesiveness between two such layers. For example, USP Nos. 292,501 and 44,563 disclose that an acrylic emulsion or a water insoluble vinyl pyrrolidone-vinyl acetate copolymer mixed with a hydrophilic polymer, formed mainly with polyvinyl alcohol in an amount of from 20 to 60% by weight, and accumulated on a polymerized layer provides sufficient adhesiveness. These known techniques can be applied to the protective layer of the present invention. A coating method for forming the protective layer is described in detail, for example, in USP No. 3,458,311 and JP-A No. 55-49729.

The protective layer may be imparted with other functions. For example, a safe light aptitude can be further improved without causing reduction in sensitivity by adding a coloring agent (such as a water soluble dye) that is excellent in transmittance with respect to light used for exposure (for example, a wavelength of from 760 to 1,200 nm for an infrared laser) and can effectively absorb light having significantly different wavelengths than that used for the exposure.

On the support thus obtained via the prescribed treatments, the photosensitive layer, the surface protective layer, the back coating layer and other arbitrary layers are formed to obtain a original lithographic printing plate having a negative recording layer, to which the method of the present invention can be applied. In the process for forming an image of the present invention, image recordation is carried out on the original lithographic printing plate with an infrared laser. Thermal recording with an ultraviolet lamp and a thermal head can also be carried out. In the present invention, imagewise exposure is preferably effected with a solid laser or a semiconductor laser emitting an infrared ray having a wavelength of from 760 to 1,200 nm. The output power of the laser is preferably no less than 100 mW, and in order to shorten the exposure time, a multi-beam laser device is preferably used. The exposure time per pixel is preferably no more than 20 microseconds. The energy applied to the recording material is preferably within a range from 10 to 300 $mJ/cm^2$.

The image forming material is exposed with an infrared laser light, and then developed with the developer composition of the present invention described in detail.

The negative image forming material applied to the method for forming an image of the present invention is a so-called heat mode image forming material, in which an infrared absorbent in a recording layer generates heat upon irradiation of an infrared laser, and radicals are formed from the radical generator with heat thus generated to advance the curing reaction, such as condensation or polymerization, of a radically polymerizable compound, whereby an image is formed. The image forming material is different from a photon mode image forming material containing a photopolymer and causing a curing reaction with irradiated light, and there are some cases where distributions occur in degree of progress of the curing reaction in the recording layer after exposure. This is because in the vicinity of the interface between the recording layer and the support, the heat thus generated is diffused to the support but is not sufficiently used for the curing reaction, and thus the degree of progress of the curing reaction becomes lower than the degree of progress of the curing reaction in the surface part of the recording layer.

In the heat mode image forming material, in which image formation is carried out by advancing curing reaction by using heat generated by irradiation with an infrared laser, there are regions having uneven physical property and uneven characteristics, in which a sufficiently cured portion and a portion of an insufficient degree of progress of the curing reaction are present as a mixture in the depth direction of the recording layer in the exposed portion. Therefore, in order to attain excellent image forming property and to attain excellent time lapse stability, such developing conditions are required that are completely different from those for the so-called photon mode image forming material, such as a photopolymer series image forming material, in which a uniform curing reaction isotropically occurs corresponding to the irradiated exposure amount. The developer composition of the present invention is prepared to achieve considerable effects when it is applied to the heat mode image forming material.

The lithographic printing plate thus developed with the developing solution and the replenisher is subjected to post processing with washing water, a rinsing solution containing a surfactant, and a moistening solution containing gum arabic and a starch derivative, and then used as a lithographic printing plate.

An automatic developing machine for printing plates is widely used, in recent years, in the fields of plate making and printing in order for rationalization and standardization of plate making operations. The automatic developing machine generally contains a developing part and a post processing part, and furthermore a mechanism for transporting a printing plate, processing baths and spraying devices. An exposed printing plate is transported in a horizontal direction and is sprayed with a processing solution drawn with a pump to effect the development process. In recent years, it is also known that a printing plate is processed in such a manner that it is transferred in the liquid

contained in the processing bath filled with the processing solution with guide rolls. In the automatic processing, the processing may be carried out by supplying a replenisher to the processing solution corresponding to the processed amount or the operation time. It is also possible that the replenisher is automatically supplied by sensing the electroconductivity with a sensor. The developer composition of the invention can also be preferably used in the automatic developing machine.

The lithographic printing plate thus obtained can be coated with a moistening gum as necessary and then subjected to a printing step, and in the case where a lithographic printing plate having further higher printing durability is to be obtained, a burning treatment is carried out.

In the case where the lithographic printing plate is subjected to the burning treatment, it is preferred that, before subjecting to the burning treatment, the printing plate is treated with a surface conditioning liquid disclosed in JP-B Nos. 61-2518 and 55-28062, and JP-A Nos. 62-31859 and 61-159655.

Examples of method for coating the surface conditioning liquid include a method, in which the surface conditioning liquid is coated on the lithographic printing plate with sponge or absorbent cotton impregnated with the surface conditioning liquid, a method of dipping the printing plate in a tray filled with the surface conditioning liquid, and a method utilizing an automatic coater. After coating, the coated amount may be uniformed by a squeegee or a squeegee roller to provide better results.

In general, the coating amount of the surface conditioning liquid is preferably within a range from 0.03 to 0.8 $g/m^2$ (dry weight).

The lithographic printing plate coated with the surface conditioning liquid is dried as necessary, and then is heated to a high temperature with a burning processor (for example, burning processor, trade name : BP-1300, available from Fuji Photo Film Co., Ltd.). The heating temperature and the heating time thereon are in ranges of from 180 to 300°C and from 1 to 20 minutes while they vary depending on the species of the components forming the image.

The lithographic printing plate having been subjected to the burning treatment may be subjected to treatments that have been conventionally carried out, such as water washing and rubberizing, as necessary and in the case where a surface conditioning liquid containing a water soluble polymer compound has been used, a so-called moistening treatment, such as rubberizing, can be omitted.

The lithographic printing plate obtained by the method for forming an image of the invention is installed, for example, in an offset printing machine and is used for printing a large number of printed matters.

## EXAMPLES

The invention will be described with reference to the following examples, but the invention is not construed as being limited thereto.

### Example 1

Production of Support

A molten liquid of an alloy containing 99.5% or more of aluminum, 0.30% of Fe, 0.10% of Si, 0.02% of Ti and 0.013% of Cu was subjected to a cleaning treatment and then cast. In the cleaning treatment, the molten liquid was subjected to degasification to remove unnecessary gases, such as hydrogen, in the molten liquid, and was filtered with a ceramic tube filter. The casting method was a DC casting method. An ingot having a plate thickness of 500 mm thus solidified was shaved from the surface thereof by 10 mm, and then subjected to homogenization at 550°C for 10 hours to prevent intermetallic compounds from becoming coarse. Subsequently, the ingot was subjected to hot rolling at 400°C, and after annealing in a continuous annealing furnace at 500°C for 60 seconds, it was subjected to cold rolling to provide an aluminum rolled plate having a thickness of 0.30 mm. The average surface roughness Ra of a center line of the rolled plate after the cold rolling is controlled to 0.2 µm by adjusting the roughness. Thereafter, the rolled plate was subjected to a tension leveler for improving the planarity.

A surface treatment was carried out to form a support for a lithographic printing plate.

In order to remove an rolling oil from the surface of the aluminum plate, a degreasing treatment was carried out with a 10% sodium aluminate aqueous solution at 50°C for 30 seconds, and then a neutralization and smut removal treatment was carried out with a 30% sulfuric acid at 50°C for 30 seconds.

The surface of the support was then roughened by a so-called toothing treatment to improve the adhesiveness between the support and a photosensitive layer and to impart water holding property to a non-image portion. An aqueous solution containing 1% of nitric acid and 0.5% of aluminum nitrate was maintained at 45°C, and an aluminum web was conveyed in the aqueous solution and was applied with a electricity of a quantity on an anode side of 240 $C/dm^2$ at an electric current density of 20 $A/dm^2$ with an alternating wave form having a duty ratio of 1/1 from an indirect power feeding cell, so as to carry out electrolytic toothing. Thereafter, etching was carried out with a 10% sodium aluminate

aqueous solution at 50°C for 30 seconds, and then a treatment for neutralization and smut removal was carried out with a 30% sulfuric acid at 50°C for 30 seconds.

Furthermore, in order to improve abrasion resistance, chemical resistance and water holding property, an oxide film was formed on the support by anodic oxidation. A 20% sulfuric acid aqueous solution at 35°C was used as an electrolyte, and the aluminum web was conveyed in the electrolyte and was subjected to an electrolytic treatment with a direct current of 14 A/$dm^2$ from an indirect power feeding cell to form an anodic oxidized film of 2.5 g/$m^2$.

Thereafter, in order to assure hydrophilicity of a non-image portion of the printing plate, a silicate treatment was carried out. A 1.5% sodium silicate No. 3 aqueous solution was maintained at 70°C, and the aluminum web was conveyed therein to make a contact time of 15 seconds, followed by water washing. The attached amount of Si was 10 mg/$m^2$. The support thus produced had an Ra (center line surface roughness) of 0.25 μm.

Undercoating

The following undercoating composition was coated on the aluminum support with a wire bar and dried by using a hot air dryer at 90°C for 30 seconds. The coated amount after drying was 10 mg/$m^2$.

The composition of the undercoating composition was as follows.

| | |
|---|---|
| Copolymer of ethyl methacrylate and sodium 2-acrylamide-2-methyl-1-propanesulfonate (copolymerization ratio: 75/15 by mole) | 0.1 g |
| 2-Aminoethylsulfonic acid | 0.1 g |
| Methanol | 50 g |
| Ion exchanged water Photosensitive Layer | 50 g |

The following coating composition (P) for a photosensitive layer was prepared and coated on the aluminum plate having the undercoating by using a wire bar, followed by drying in a hot air dryer at 115°C for 45 seconds, to form a photosensitive layer. The resulting negative original lithographic printing plate (P-1) was designated as Example 1. The coated amount after drying was in a range of from 1.2 to 1.3 g/$m^2$.

The composition of the coating composition (P) for a photosensitive layer was as follows.

| | |
|---|---|
| Infrared absorbent (IR-6) | 0.08 g |
| Onium salt (OI-6) | 0.30 g |
| Dipentaerythritol hexaacrylate Copolymer of allyl methacrylate and methacrylic acid | 1.00 g |
| (copolymerization ratio: 80/20 by mole) (weight average molecular weight: 120,000) | 1.00 g |
| Naphthalenesulfonate of Victoria Pure Blue Fluorine surfactant (trade name: MEGAFAC F176, | 0.04 g |
| produced by Dainippon Ink and Chemicals, Inc.) | 0.01 g |
| Methyl ethyl ketone | 9.0 g |
| Methanol | 10.0 g |
| 1-Methoxy-2-propanol | 4.0 g |
| 3-Methoxy-1-propanol | 4.0 g |

[IR-6}

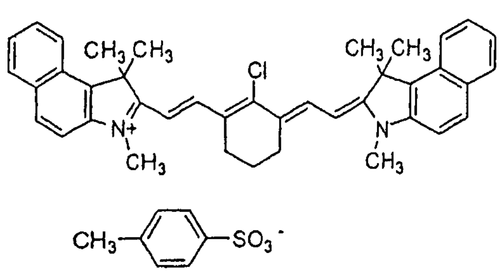

[OI-6]

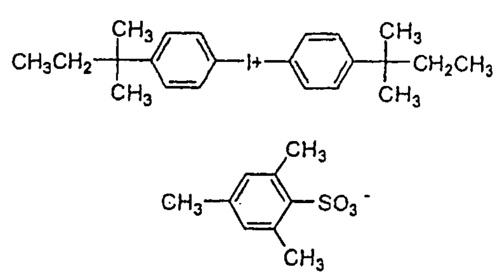

Exposure

The resulting negative original lithographic printing plate (P-1) was exposed with Trendsetter 3244 VFS, a trade name, produced by Creo Corp. having a water-cooled 40 W infrared ray semiconductor laser installed therein at an output power varying from 3 to 9 W, a rotation number of an outer drum varying from 65 to 350 rpm, an energy on a plate surface varying from 30 to 300 $mJ/cm^2$ under conditions of a resolution of 2,400 dpi. Development Treatment
A development treatment was carried out by using an automatic developing machine, trade name: STABLON 900N, produced by Fuji Photo Film Co., Ltd after exposure. For both a charged solution and a replenisher of the developing solution, a developing solution (1) having the following composition (pH 11.9 at 25°C) was used. The temperature of the developing bath was 30°C. As a finisher, a 1/1 water-diluted solution of FP-2W, (trade name, produced by Fuji Photo Film Co., Ltd) was used. The pH values of developing solutions referred herein are those measured at 25°C.
The composition of the developing solution (1) was as follows.

| | |
|---|---|
| Potassium hydroxide Surfactant of Compound No. 4 | 0.7 g |
| (inorganicity/organicity value: 1.66) | 30 g |
| Sodium sulfite | 1 g |
| Tetrasodium ethylenediimine tetraacetate | 0.1 g |
| Ion exchanged water | 966.2 g |

Evaluation of Image Forming Sensitivity

A lithographic printing plate having a solid image, a halftone dot image and thin lines on the plate formed completely was obtained after development at an exposure amount of 100 $mW/cm^2$ or more. Thus, the image forming sensitivity of the development system using the developing solution was evaluated as 100 $mW/cm^2$.

Evaluation of Printing Durability and Contamination

The resulting lithographic printing plate was subjected to printing by using a printing machine, LITHRONE (trade name, produced by Komori Corp) . A number of printed matters having a printed ink of a sufficient density obtained after the start of printing was evaluated by visual inspection. The state of contamination of the non-image portion was also evaluated at this time by visual inspection.
As a result, 80,000 sheets of printed matters of good conditions were obtained. Formation of contamination was not observed on the non-image portion of the resulting printed matters.

Evaluation of Time-lapse Stability

The development operation was continuously carried out by the automatic developing machine under the conditions of Example 1 at 10 $m^2$ per day for 20 days, and no dropout of images nor development failure was observed on the resulting lithographic printing plates.

Example 2

A printing plate was produced in the same manner as in Example 1 except that a developing solution (2) having the following composition was used instead of the developing solution (1) used for development in Example 1. (pH of developing solution (2): 11.9)
The composition of the developing solution (2) was as follows.

| | |
|---|---|
| Potassium hydroxide | 0.7 g |
| Potassium carbonate Surfactant of Compound No. 11 | 2 g |
| (inorganicity/organicity value: 1.47) | 50 g |
| Potassium sulfite | 1 g |
| Tetrasodium ethylenediimine tetraacetate | 0.1 g |
| Ion exchanged water | 966.2 g |

Example 3

A printing plate was produced in the same manner as in Example 1 except that a developing solution (3)

having the following composition was used instead of the developing solution (1) used for development in Example 1. (pH of developing solution (3): 12.3)

The composition of the developing solution (3) was as follows.

| | |
|---|---|
| Potassium hydroxide | 0.5 g |
| Potassium phosphate Surfactant of Compound No. 5 | 3 g |
| (inorganicity/organicity value: 1.71) | 25 g |
| Potassium sulfite | 1 g |
| Tetrasodium ethylenediimine tetraacetate | 0.1 g |
| Ion exchanged water | 970.4 g |

Example 4

A printing plate was produced in the same manner as in Example 1 except that a developing solution (4) having the following composition was used instead of the developing solution (1) used for development in Example 1. (pH of developing solution (4): 10.6)

The composition of the developing solution (4) was as follows.

| | |
|---|---|
| Potassium hydrogencarbonate | 2 g |
| Potassium carbonate Surfactant of Compound No. 17 | 2.5 g |
| (inorganicity/organicity value: 1.47) | 40 g |
| Potassium sulfite | 1 g |
| Tetrasodium ethylenediimine tetraacetate | 0.3 g |
| Ion exchanged water | 954.2 g |

Example 5

A printing plate was produced in the same manner as in Example 1 except that a developing solution (5) obtained by replacing the Compound No. 1 in the developing solution (1) with the Compound No. 22 (inorganicity/organicity value: 1.33) and replacing potassium hydroxide in the developing solution (1) with potassium hydrogencarbonate was used instead of the developer solution (1) used for development in Example 1. (pH of developing solution (5): 10.6)

Example 6

A printing plate was produced in the same manner as in Example 1 except that a developing solution (6) having the following composition was used instead of the developing solution (1) used for development in Example 1. (pH of developing solution (6): 12.9)

The composition of the developing solution (6) was as follows.

| | |
|---|---|
| Potassium silicate No. 3 | 3 g |
| Potassium hydroxide Surfactant of Compound No. 4 | 4 g |
| (inorganicity/organicity value: 1.66) | 20 g |
| Potassium sulfite | 1 g |
| Tetrasodium ethylenediimine tetraacetate | 0.1 g |
| Ion exchanged water | 966.2 g |

Comparative Example 1

A negative lithographic printing plate was produced in the same manner as in Example 1 except that a comparative developing solution (1) (pH 11.9) having the following composition was used instead of the developing solution (1) used for development in Example 1.

The composition of the comparative developing solution (1) was as follows.

| | |
|---|---|
| Potassium hydroxide | 0.7 g |

(continued)

| | |
|---|---|
| Sodium sulfite | 1 g |
| Sodium butylnaphthalenesulfonate | 20 g |
| Tetrasodium ethylenediimine tetraacetate | 0.1 g |
| Ion exchanged water | 938.9 g |

Comparative Example 2

A negative lithographic printing plate was produced in the same manner as in Example 1 except that a comparative developing solution (2) (pH 8.9) having the following composition was used instead of the developing solution (1) used for development in Example 1.

The composition of the comparative developing solution (2) was as follows.

| | |
|---|---|
| Potassium hydrogencarbonate | 12 g |
| Sodium sulfite | 1 g |
| Sodium dibutylnaphthalenesulfonate | 20 g |
| Tetrasodium ethylenediimine tetraacetate | 0.1 g |
| Ion exchanged water | 938.9 g |

Comparative Example 3

A negative lithographic printing plate was produced in the same manner as in Example 1 except that a comparative developing solution (3) (pH 11.6) having the following composition was used instead of the developing solution (1) used for development in Example 1.

The composition of the comparative developing solution (3) was as follows.

| | |
|---|---|
| Potassium hydroxide | 0.7 g |
| Potassium carbonate | 3 g |
| Sodium butylnaphthalenesulfonate | 30 g |
| Benzyl alcohol | 20 g |
| Sodium sulfite | 1 g |
| Tetrasodium ethylenediimine tetraacetate | 0.1 g |
| Ion exchanged water | 938.9 g |

The lithographic printing plates obtained in Examples 2 to 6 and Comparative Examples 1 to 3 were subjected to printing in the same manner as in Example 1, and the evaluations were carried out in the same manners. The results obtained are shown in Table 9 below. The time-lapse stability of the developing solutions was evaluated in the same manner as in Example 1.

The results thereof are also shown in Table 9.

Table 9

| | | | | Time-lapse | stability |
|---|---|---|---|---|---|
| | Sensitivity (mW/$cm^2$) | Printing durability | Contamination property | Dropout of image | Development failure |
| Example 2 | 130 | ≥ 80,000 sheets | A | A | A |
| Example 3 | 90 | ≥ 80,000 sheets | A | A | A |
| Example 4 | 110 | ≥ 80,000 sheets | A | A | A |
| Example 5 | 130 | ≥ 80,000 sheets | A | A | A |
| Example 6 | 80 | ≥ 80,000 sheets | A | A | A |
| Comparative Example 1 | 180 | 1,000 sheets | A | C | A |

Table 9 (continued)

| | | | | Time-lapse | stability |
|---|---|---|---|---|---|
| | Sensitivity (mW/ $cm^2$) | Printing durability | Contamination property | Dropout of image | Development failure |
| Comparative Example 2 | 200 | ≥ 80,000 sheets | C | A | C |
| Comparative Example 3 | 210 | 500 sheets | A | C | A |
| (Throughout Tables 9 to 12, Contamination property A: no stain was observed on printed matters Contamination property C: stains were observed on printed matters Dropout of image A: no dropout of images nor development failure was observed on image portions of the resulting lithographic printing plates after 80,000 sheets of printed matters of good conditions were obtained Dropout of image C: development failure was observed on image portions of the resulting lithographic printing plates Development failure A: no development failure was observed on non-image portions of the resulting lithographic printing plates Development failure C: development failure was observed on non-image portions of the resulting lithographic printing plates.) | | | | | |

It was found from the results shown in Table 9 that Examples 2 to 6 using a weak alkaline aqueous solution containing a nonionic surfactant for development were excellent in all image formation sensitivity, printing durability and developing property, and furthermore, development could be stably carried out for a long period of time. On the other hand, in Comparative Examples 1 and 3 using a developer having no nonionic surfactant added, dropouts of images occurred, and the printing durability was poor in comparison to Examples 2 to 5. In Comparative Example 2 using a developer having a pH of 8.9, contamination occurred due to development failure.

Examples 7 to 46

Developing solutions were produced in the same formula as the developing solution (3) used in Example 3 except that the nonionic surfactant used in the developing solution (3) was replaced with the compounds (7) to (46) shown in Table 10 below, and negative lithographic printing plates were produced in the same manner as in Example 3.

The lithographic printing plates produced in Examples 6 to 46 were subjected to printing in the same manner as in Example 1, and the evaluations were carried out in the same manner as in Example 1. The results obtained are shown in Tables 10 to 12 below. The time-lapse stability of the developing solutions was evaluated in the same manner as in Example 1. The results thereof are also shown in Tables 10 to 12.

Table 10

| | General formula of surface active agent | Example compound No. | I/O value | Sensitivity ($mW/cm^2$) | Printing durability (sheets) | Contamination property | Time-lapse stability | |
|---|---|---|---|---|---|---|---|---|
| | | | | | | | Dropout of image | Development failure |
| Example 7 | General formula (1) | 1 | 1.34 | 170 | 80,000 | A | A | A |
| Example 8 | | 2 | 0.96 | 180 | 40,000 | A | B | A |
| Example 9 | | 3 | 1.58 | 150 | 80,00 | A | A | A |
| Example 10 | | 4 | 1.66 | 130 | 80,000 | A | A | A |
| Example 3 | | 5 | 1.71 | 110 | 80,000 | A | A | A |
| Example 11 | | 6 | 0.91 | 190 | 60,000 | A | B | A |
| Example 12 | | 7 | 1.01 | 180 | 70,000 | A | A | A |
| Example 13 | | 8 | 1.28 | 170 | 80,000 | A | A | A |
| Example 14 | General formula (2) | 9 | 1.20 | 180 | 70,000 | A | A | A |
| Example 15 | | 10 | 1.33 | 170 | 80,000 | A | A | A |
| Example 16 | | 11 | 1.47 | 150 | 80,000 | A | A | A |
| Example 17 | | 12 | 1.68 | 130 | 80,000 | A | A | A |
| Example 18 | | 13 | 1.75 | 110 | 80,000 | A | A | A |
| Example 19 | | 14 | 0.99 | 180 | 60,000 | A | A | A |
| Example 20 | | 15 | 1.53 | 150 | 80,000 | A | A | A |

(Dropout of image B: no development failure was observed on image portions of the resulting lithographic printing plates, however, dropout of images and development failure were observed after 20,000 sheets of printed matters were obtained)

Table 11

| | General formula of surface active agent | Example compound No. | I/O value | Sensitivity ($mW/cm^2$) | Printing durability (sheets) | Contamination property | Time-lapse stability | |
|---|---|---|---|---|---|---|---|---|
| | | | | | | | Dropout of image | Development failure |
| Example 21 | General formula (3) | 16 | 1.08 | 180 | 70,000 | A | A | A |
| Example 22 | | 17 | 1.33 | 170 | 80,000 | A | A | A |
| Example 23 | | 18 | 1.54 | 150 | 80,000 | A | A | A |
| Example 24 | | 19 | 1.71 | 110 | 80,000 | A | A | A |
| Example 25 | | 20 | 1.26 | 170 | 80,000 | A | A | A |
| Example 26 | | 21 | 0.94 | 180 | 70,000 | A | B | A |
| Example 27 | | 22 | 1.41 | 150 | 80,000 | A | A | A |
| Example 28 | General formula (4) | 23 | 1.03 | 180 | 70,000 | A | A | A |
| Example 29 | | 24 | 1.32 | 170 | 80,000 | A | A | A |
| Example 30 | | 25 | 1.55 | 150 | 80,000 | A | A | A |
| Example 31 | | 26 | 0.78 | 210 | 50,000 | A | B | A |
| Example 32 | | 27 | 1.27 | 170 | 80,000 | A | A | A |
| Example 33 | | 28 | 1.59 | 150 | 80,000 | A | A | A |
| Example 34 | | 29 | 1.71 | 100 | 80,000 | A | A | A |

Table 12

| | General formula of surface active agent | Example compound No. | I/O value | Sensitivity ($mW/cm^2$) | Printing durability (Sheets) | Contamination property | Time-lapse stability | |
|---|---|---|---|---|---|---|---|---|
| | | | | | | | Dropout of image | Development failure |
| Example 35 | General formula (5) | 30 | 1.40 | 160 | 80,000 | A | A | A |
| Example 36 | | 31 | 1.70 | 100 | 80,000 | A | A | A |
| Example 37 | | 32 | 1.42 | 160 | 80,000 | A | A | A |
| Example 38 | | 33 | 1.64 | 140 | 80,000 | A | A | A |
| Example 39 | General formula (6) | 34 | 1.13 | 180 | 80,000 | A | A | A |
| Example 40 | | 35 | 1.43 | 160 | 80,000 | A | A | A |
| Example 41 | | 36 | 1.59 | 150 | 80,000 | A | A | A |
| Example 42 | | 37 | 1.42 | 160 | 80,000 | A | A | A |
| Example 43 | | 38 | 1.58 | 140 | 80,000 | A | A | A |
| Example 44 | General formula (7) | 39 | 1.18 | 180 | 80,000 | A | A | A |
| Example 45 | | 40 | 1.31 | 160 | 80,000 | A | A | A |
| Example 46 | | 41 | 1.55 | 130 | 80,000 | A | A | A |
| Example 47 | | 42 | 1.67 | 110 | 80,000 | A | A | A |
| Example 48 | General formula (8) | 43 | 0.85 | 200 | 70,000 | A | B | A |
| Example 49 | | 44 | 1.17 | 180 | 80,000 | A | A | A |
| Example 50 | | 45 | 1.34 | 160 | 80,000 | A | A | A |
| Example 51 | | 46 | 0.60 | 200 | 60,000 | A | B | A |
| Example 52 | | 47 | 1.22 | 180 | 80,000 | A | A | A |
| Example 53 | | 48 | 1.46 | 160 | 80,000 | A | A | A |

It was found from the results shown in Tables 10 to 12 that in the cases where all the compounds represented by the general formulae (1) to (8) as preferred examples of the nonionic surfactant of the invention, the lithographic printing plates of Examples 7 to 46 obtained by the process for forming an image of the invention using the developer composition of the invention were excellent in all image formation sensitivity, printing durability and developing property, and furthermore, the time-lapse stability was excellent to carry out development for a long period of time as in Examples 1 to 6.

The developer composition of the invention can be preferably applied to a lithographic printing plate having a negative recording layer capable of being directly recorded from digital computer data through recordation using a solid laser or a semiconductor laser emitting an infrared ray, and exerts such effects that it is excellent in image formation property but causes no time-lapse reduction in development property or printing durability caused by characteristics of the developer. Furthermore, according to the process for forming an image on a negative lithographic printing plate using the developer composition of the invention, such a lithographic printing plate can be produced that has high sensitivity and can form a large number of images in good conditions.

## Claims

1. A composition for developing a lithographic printing plate including a negative recording layer on which an image is recorded by exposure to an infrared laser, the composition comprising a nonionic surfactant.

2. The composition according to claim 1, wherein the nonionic surfactant has an inorganicity/organicity value within a range of from 1.0 to 3.0.

3. The composition according to any of claims 1 and 2, further comprising a weak alkaline aqueous solution having a pH level in a range of from 9 to 14.

4. The composition according to any of claims 1 to 3, comprising an alkaline agent in an amount in a range of from 0.1 to 10% by weight based on a total amount of the developer composition.

5. The composition according to any of claims 1 to 4, wherein the nonionic surfactant contains at least one compound represented by the following general formulae (1) to (8) :

General Formula (1)

$$C_pH_{2p+1}-O(CH_2CH_2O)n(CH_2CH(CH_3)O)mH$$

General Formula (2)

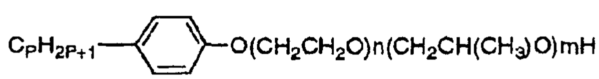

General Formula (3)

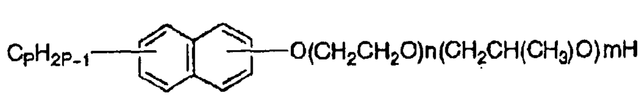

General Formula (4)

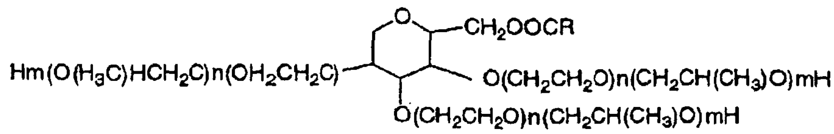

General Formula (5)

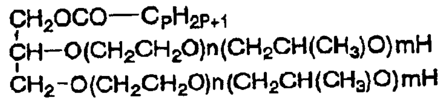

General Formula (6)

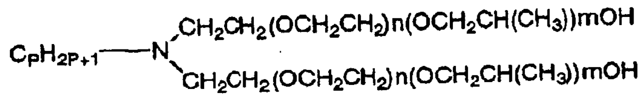

General Formula (7)

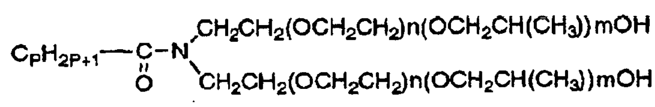

General Formula (8)

$$HO(CH_2CH_2O)n-(CH_2CH(CH_3)O)m-(CH_2CH_2O)_lH$$

wherein 1, m, n and p each represent an integer of 1 or greater.

**6.** The composition according to any of claims 1 to 5, wherein an amount of the nonionic surfactant is from 0.2 to 30% by weight based on a total amount of the developer composition.

**7.** A process for forming an image on a lithographic printing plate, the process comprising the steps of: imagewise exposing an original lithographic printing plate including a negative recording layer on which an image is recorded by exposure to an infrared ray, the negative recording layer containing an infrared ray absorbent, a radical generator and a radically polymerizable compound; and then developing the lithographic printing plate via a developer composition containing a nonionic surfactant.

**8.** The process according to claim 7, wherein the nonionic surfactant has an inorganicity/organicity value within a range of from 1.0 to 3.0.

**9.** The process according to any of claims 7 and 8, wherein the nonionic surfactant contains at least one compound represented by the following general formulae (1) to (8) :

General Formula (1)

$C_PH_{2P+1}-O(CH_2CH_2O)n(CH_2CH(CH_3)O)mH$

General Formula (2)

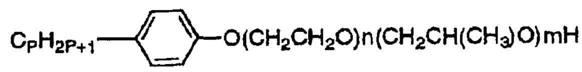

General Formula (3)

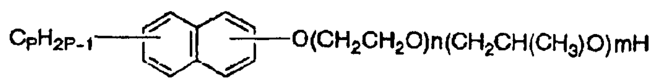

General Formula (4)

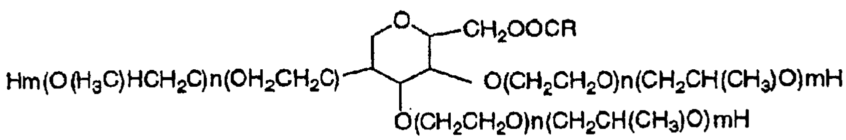

General Formula (5)

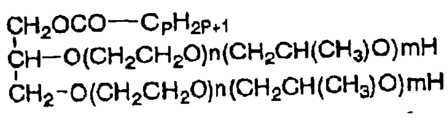

General Formula (6)

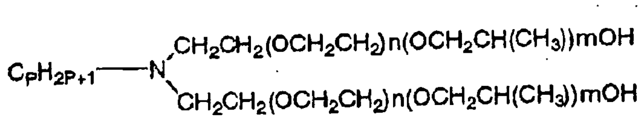

General Formula (7)

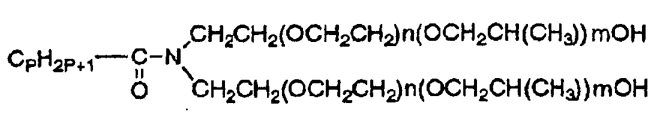

General Formula (8)

$$HO(CH_2CH_2O)n-(CH_2CH(CH_3)O)m-(CH_2CH_2O)_lH$$

wherein 1, m, n and p each represent an integer of 1 or greater.

**10.** The process according to any of claims 7 to 9, wherein the infrared absorbent contains at least one of a cyanine dye, a squalirium dye, a pyrylium salt and a nickel thiolate complex.

**11.** The process according to any of claims 7 to 10, wherein the infrared absorbent exhibits an optical density within a range of from 0.1 to 3.0 at an absorption maximum at a wavelength within a range of from 760 to 1,200 nm in the photosensitive layer of the original lithographic printing plate.

**12.** The process according to any of claims 7 to 11, wherein the radical generator contains at least one of an onium salt, a triazine compound having a trihalomethyl group, a peroxide, an azo polymerization initiator, an azide compound and a quinone diazide.

**13.** The process according to any of claims 7 to 12, wherein the radical generator contains at least one of onium salts represented by the following general formulae (III) to (V) :

General Formula (III) $$Ar^{11}-\overset{+}{I}-Ar^{12} \quad Z^{11-}$$

General Formula (IV) $$Ar^{21}-\overset{+}{N}\equiv N \quad Z^{21-}$$

General Formula (V) 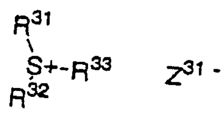

wherein $Ar^{11}$, $Ar^{12}$ and $Ar^{21}$ each independently represents an aryl group having no greater than 20 carbon atoms, which may have a substituent; $Z^{11-}$, $Z^{21-}$ and $Z^{31-}$ each represent a counter ion selected from the group consisting of a halogen ion, a perchlorate ion, a tetrafluoroborate ion, a hexafluoroborate ion and a sulfonate ion; and $R^{31}$, $R^{32}$ and $R^{33}$, which may be the same or different, each represent a hydrocarbon group having no greater than 20 carbon atoms, which may have a substituent.

**14.** The process according to any of claims 7 to 13, wherein the radical generator has a maximum absorption wavelength of no greater than 400 nm.

**15.** The process according to any of claims 7 to 14, wherein the radical generator is contained in an amount of from 0.1 to 50% by weight based on a total solid content of a coating composition for the photosensitive layer.

European Patent Office

# EUROPEAN SEARCH REPORT

Application Number
EP 02 01 1306

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 096 315 A (FUJI PHOTO FILM CO LTD) 2 May 2001 (2001-05-02) * paragraph '0131! - paragraph '0132! * --- | 1,7,10, 13 | G03F7/32 B41C1/10 |
| A | EP 1 072 955 A (FUJI PHOTO FILM CO LTD) 31 January 2001 (2001-01-31) * the whole document * --- | 1,7 | |
| X | EP 0 992 854 A (AGFA GEVAERT AG) 12 April 2000 (2000-04-12) * claims 11,13; tables * --- | 1-4 | |
| P,X | EP 1 110 747 A (FUJI PHOTO FILM CO LTD) 27 June 2001 (2001-06-27) * paragraph '0022! - paragraph '0023!; examples * --- | 7 | |
| X | EP 0 556 014 A (TADAHIRO OHMI ;CANON KK (JP)) 18 August 1993 (1993-08-18) * claims; examples 10,11 * --- | 1-6 | TECHNICAL FIELDS SEARCHED (Int.Cl.7) |
| X | DE 197 55 131 A (SIEMENS AG) 24 June 1999 (1999-06-24) * the whole document * --- | 1-6 | G03F B41C |
| X | WO 99 00707 A (CLARIANT INT LTD ;YOSHIKAWA KATSUHIRO (JP); YOSHIDA MITSUTOSHI (JP) 7 January 1999 (1999-01-07) * abstract * --- | 1-6 | |
| X | US 5 731 132 A (ELTGEN MARLIES ET AL) 24 March 1998 (1998-03-24) * claims; examples * --- -/-- | 1-6 | |

The present search report has been drawn up for all claims

| Place of search | Date of completion of the search | Examiner |
|---|---|---|
| THE HAGUE | 2 August 2002 | Heywood, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

# EUROPEAN SEARCH REPORT

Application Number
EP 02 01 1306

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DATABASE WPI<br>Section Ch, Week 198530<br>Derwent Publications Ltd., London, GB;<br>Class A89, AN 1985-181759<br>XP002208491<br>& JP 60 111246 A (FUJI PHOTO FILM CO LTD),<br>17 June 1985 (1985-06-17)<br>* abstract *<br>--- | 1-6 | |
| X | DATABASE WPI<br>Section Ch, Week 198735<br>Derwent Publications Ltd., London, GB;<br>Class A89, AN 1987-246256<br>XP002208492<br>& JP 62 168160 A (KONISHIROKU PHOTO IND CO LTD), 24 July 1987 (1987-07-24)<br>* abstract *<br>--- | 1-6 | |
| P,X | EP 1 172 699 A (FUJI PHOTO FILM CO LTD)<br>16 January 2002 (2002-01-16)<br>* paragraph '0232! *<br>--- | 1-15 | TECHNICAL FIELDS SEARCHED (Int.Cl.7) |
| X | US 5 994 031 A (SUGI YASUHISA ET AL)<br>30 November 1999 (1999-11-30)<br>* column 13, line 10 - line 16 *<br>----- | 1-6 | |

The present search report has been drawn up for all claims

| Place of search | Date of completion of the search | Examiner |
|---|---|---|
| THE HAGUE | 2 August 2002 | Heywood, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 02 01 1306

This annex lists the patent family members relating to the patent documents cited in the above-mentioned European search report.
The members are as contained in the European Patent Office EDP file on
The European Patent Office is in no way liable for these particulars which are merely given for the purpose of information.

02-08-2002

| Patent document cited in search report | | Publication date | Patent family member(s) | | Publication date |
|---|---|---|---|---|---|
| EP 1096315 | A | 02-05-2001 | JP 2001125260 | A | 11-05-2001 |
| | | | JP 2001133969 | A | 18-05-2001 |
| | | | EP 1096315 | A1 | 02-05-2001 |
| EP 1072955 | A | 31-01-2001 | JP 2001042508 | A | 16-02-2001 |
| | | | JP 2001042538 | A | 16-02-2001 |
| | | | EP 1072955 | A2 | 31-01-2001 |
| | | | US 6423462 | B1 | 23-07-2002 |
| EP 0992854 | A | 12-04-2000 | DE 19845605 | A1 | 06-04-2000 |
| | | | EP 0992854 | A1 | 12-04-2000 |
| | | | JP 2000206706 | A | 28-07-2000 |
| | | | US 6365330 | B1 | 02-04-2002 |
| EP 1110747 | A | 27-06-2001 | JP 2001175004 | A | 29-06-2001 |
| | | | EP 1110747 | A1 | 27-06-2001 |
| | | | US 2002033109 | A1 | 21-03-2002 |
| EP 0556014 | A | 18-08-1993 | AT 172551 | T | 15-11-1998 |
| | | | DE 69321627 | D1 | 26-11-1998 |
| | | | DE 69321627 | T2 | 22-04-1999 |
| | | | EP 0556014 | A1 | 18-08-1993 |
| | | | JP 5308048 | A | 19-11-1993 |
| | | | JP 5303209 | A | 16-11-1993 |
| | | | KR 123931 | B1 | 20-11-1997 |
| | | | US 6107007 | A | 22-08-2000 |
| DE 19755131 | A | 24-06-1999 | DE 19755131 | A1 | 24-06-1999 |
| | | | WO 9930210 | A1 | 17-06-1999 |
| | | | EP 1051666 | A1 | 15-11-2000 |
| WO 9900707 | A | 07-01-1999 | JP 11024285 | A | 29-01-1999 |
| | | | WO 9900707 | A1 | 07-01-1999 |
| US 5731132 | A | 24-03-1998 | DE 4419166 | A1 | 07-12-1995 |
| | | | CN 1117599 | A | 28-02-1996 |
| | | | DE 59508636 | D1 | 21-09-2000 |
| | | | EP 0685767 | A1 | 06-12-1995 |
| | | | JP 7333863 | A | 22-12-1995 |
| | | | SG 34226 | A1 | 06-12-1996 |
| JP 60111246 | A | 17-06-1985 | JP 1686835 | C | 11-08-1992 |
| | | | JP 3054339 | B | 19-08-1991 |
| JP 62168160 | A | 24-07-1987 | JP 2085242 | C | 23-08-1996 |
| | | | JP 7113768 | B | 06-12-1995 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO. EP 02 01 1306

This annex lists the patent family membersrelating to the patent documents cited in the above-mentioned European search report.
The members are as contained in the European Patent Office EDP file on
The European Patent Office is in no way liable for these particulars which are merely given for the purpose of information.

02-08-2002

| Patent document cited in search report | | Publication date | Patent family member(s) | | | Publication date |
|---|---|---|---|---|---|---|
| EP 1172699 | A | 16-01-2002 | JP | 2002091016 | A | 27-03-2002 |
| | | | EP | 1172699 | A1 | 16-01-2002 |
| | | | US | 2002092436 | A1 | 18-07-2002 |
| US 5994031 | A | 30-11-1999 | JP | 10133391 | A | 22-05-1998 |

EPO FORM P0459

For more details about this annex : see Official Journal of the European Patent Office, No. 12/82